# EUROPEAN PATENT SPECIFICATION

(11) **EP 0 430 595 B1**
(45) Date of publication and mention of the grant of the patent: **02.04.1997**
(21) Application number: 90312756.1
(22) Date of filing: 23.11.1990
(51) Int. Cl.: H01L 29/40, H01L 29/73

(54) **Compound semiconductor device**
Verbindungshalbleiteranordnung
Dispositif semi-conducteur composé

(30) Priority: 27.11.1989 JP 306791/89; 18.01.1990 JP 9028/90
(43) Date of publication of application: 05.06.1991
(73) Proprietor: KABUSHIKI KAISHA TOSHIBA, Kawasaki-shi, Kanagawa-ken 210 (JP)
(72) Inventor: Tsuda, Kunio, c/o Intellectual Property Div., Minato-ku, Tokyo (JP); Morizuka, Kouhei, c/o Intellectual Property Div., Minato-ku, Tokyo (JP)
(74) Representative: Freed, Arthur Woolf

(56) References cited:
- 1988 IEEE MTT INTERNATIONAL MICROWAVE SYMPOSIUM DIGEST, New York, NY, 25th - 27th May 1988, vol. II, pages 679-682, IEEE, New York, US; N. HAYAMA et al.: "A low-noise Ku-band AlGaAs/GaAS HBT oscillator"
- IEEE ELECTRON DEVICE LETTERS, vol. 10, no. 11, November 1989, pages 506-507, IEEE, New York, US; T. NITTONO et al.: "A new self-aligned AlGaAs/GaAs HBT based on refractory emitter and base electrodes"
- IEEE TRANSACTIONS ON ELECTRON DEVICES, vol. 36, no. 10, October 1989, pages
- 2196-2203, IEEE, New York, US; S. KURODA et al.: "A new fabrication technology for AlGaAs/GaAs HEMT LSI's using InGaAS nonalloyed ohmic contacts"
- APPLIED PHYSICS LETTERS, vol. 55, no. 16, 16th October 1989, pages 1650-1652, American Institute of Physics, New York, US; C.H. YANG et al.: "Implant and annealed ohmic contact to a thin quantum well"
- INTERNATIONAL ELECTRON DEVICES MEETING, TECHNICAL DIGEST 1988, San Francisco, CA, 11th - 14th December 1988, pages 680-683, IEEE, New York, US; S. KURODA et al.: "HEMT VLSI technology using nonalloyed ohmic contacts"

## Description

The present invention relates to compound semiconductor devices and more particularly, to formation of a contact to an n type AlₓGa₁₋ₓAs (0≦ x ≦ 1) material.

GaAs has been considered to offer a very promising prospect as a material for a high speed device, because the material has a mobility of about 6 times larger than that of silicon (Si) and can be easily made into a semi-insulating substrate.

And AlₓGa₁₋ₓAs obtained by adding aluminum (Al) to GaAs is very close in lattice constant to GaAs and allows good epitaxial growth with GaAs. For this reason, attention has been increasingly directed to development of heterojunction devices based on AlₓGa₁-ₓAs/GaAs heterojunction.

As a result, many sorts of devices have been developed, including, for example, an AlₓGa₁₋ₓAs/GaAs heterojunction bipolar transistor (HBT) having a wide gap emitter of AlₓGa₁₋ₓAs and a high electron mobility transistor (HEMT) having an electron supply layer of AlₓGa₁₋ₓAs.

For the purpose of enhancing the performances of these devices, it is very important to reduce the resistance of their ohmic contact.

Generally speaking, it is difficult to form an ohmic contact of low resistance on an AlₓGa₁₋ₓAs layer (0< x ≦1). For this reason, even when such an AlₓGa₁₋ₓAs layer must be placed as the top layer of a device, an n⁺ type GaAs has been formed on the AlₓGa₁₋ₓAs as a cap layer for the ohmic contact. To this end, the composition of metal material of its electrodes, the temperature of heat treatment for the formation of the alloy, etc have been correspondingly devised.

Since these GaAs and AlₓGa₁₋ₓAs materials are large in band gap and low in the upper limit of obtained electron concentration when compared with Si material, however, the reduction of the ohmic contact resistance is limited thereby.

To overcome this, there has been lately proposed a method of using InₓGa₁₋ₓAs material having a band gap smaller than the AlₓGa₁₋ₓAs or GaAs as a contact layer (refer to J. Vac. Sci. Technol., 19 (3), 1981, pp626-627).

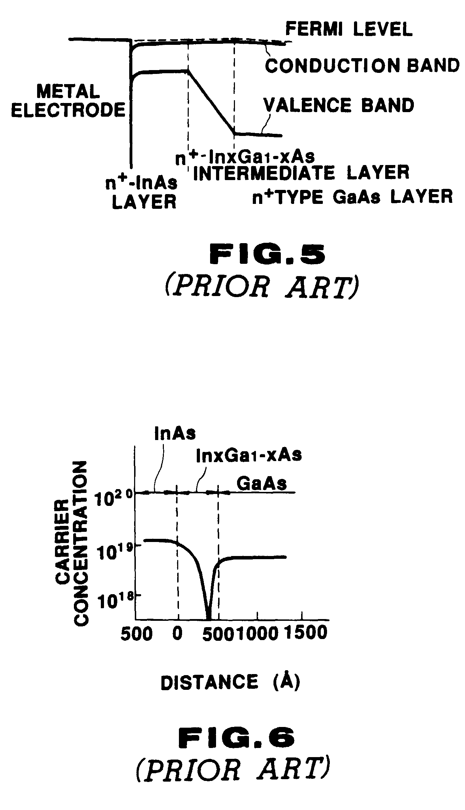

Fig. 5 shows, as one of such prior art examples, an ideal energy band between an n type GaAs layer and a metallic electrode with an n⁺ type InₓGa₁₋ₓAs layer and an n⁺ InAs layer interposed therebetween at the time of forming a contact to the n type GaAs. For the purpose of smoothly connecting together the bands of the GaAs and InAs layers, the graded-composition layer of the InₓGa₁₋ₓAs material (x = 0→ 1) is inserted between the GaAs and InAs layers. Since any Schottky barrier is not present between the InAs layer and the electrode, a low resistance contact can be obtained.

However, there is a lattice misalignment as large as about 7% between the InAs and GaAs layers.

This lattice misalignment causes the InGaAs layer to be subjected to a misfit dislocation. In the event where the thickness of the InGaAs layer is below its critical thickness, no misfit dislocation takes place. When it is desired to form an ohmic contact of lower resistance, however, it is preferable that an In mixed crystal ratio x is closer to 1 and the critical thickness becomes correspondingly smaller. When the InGaAs layer has a mixed crystal ratio x of 0.5, its critical thickness is below several ten Å (10Å = 1 nm). In addition, as the mixed crystal ratio x is closer to 1, the thickness of the InₓGa₁₋ₓAs graded-composition layer necessary for smoothly connecting the bands of the InAs and GaAs layers is larger. Meanwhile, when the element performance, process, etc are taken into consideration, it is preferable to make small the thickness of the contact layer. From these reasons, when an ohmic contact of low resistance is to be formed with use of a practical structure, the occurrence of a misfit dislocation cannot be eventually avoided.

Furthermore, the occurrence of such a misfit dislocation is concentrated, in particular, in the InₓGa₁₋ₓAs as an intermediate layer to compensate for the carriers in this area, which involves a problem that the carrier concentration is reduced.

It is known that the upper limit of the usual carrier concentration, which depends on the epitaxial growth conditions and so on, is about 2 × 10¹⁹ cm⁻³ and about 1 × 10¹⁹ cm⁻³ for InAs and GaAs respectively. In the case of the InAs/InₓGa₁₋ₓAs/GaAs structure, a large carrier concentration dip occurs, in particular, in the intermediate layer of InₓGa₁₋ₓAs. When the thickness of the InₓGa₁₋ₓAs is made sufficiently large, the dislocation density (cm⁻³) is also reduced and the carrier concentration dip is correspondingly decreased.

When consideration is paid to the application of such a structure to a semiconductor device having an n type ohmic contact, however, it is not practical to increase the layer thickness.

Turning now to Fig. 6, there is shown a measurement result of carrier concentration distribution in the InAs/InₓGa₁₋ₓAs/GaAs structure doped with silicon. In the drawing, the film thickness of the InₓGa₁₋ₓAs layer was set to be 500 Å and 1.5 × 10¹⁹ cm⁻³ of silicon was doped into the InAs and InₓGa₁₋ₓAs. As will be seen from the drawing that the carrier concentration largely drops in the InₓGa₁₋ₓAs layer and there is an area therein where the carrier concentration is substantially zero especially in the vicinity of the interface with the GaAs layer. Under such a condition, the contact resistance when a current flows in a vertical direction with respect to the semiconductor layer was as high as 5 x 10⁻⁶Ω cm².

Thus, the conventional structure has had such a problem that, even when a low-resistance contact can be obtained at the InAs/electrode interface, it is impossible for the entire contact to have a sufficiently low resistance.

In this way, the conventional method of forming the ohmic contact to the n type GaAs layer using the InₓGa₁₋ₓAs layer has had a problem that the carrier compensation caused by the misfit dislocation causes the reduction of the carrier concentration, which results in that an area having a high resistance is formed and the contact resistance becomes correspondingly large. Contact structures for compound semiconductor devices are disclosed in Appl. Phys. Lett 55(1989) 16 Oct, no. 16, pgs 1650-1652, IEEE EDC-10, no. 11 nov.'89, pgs 506-507 and IEEE ED-36 no. 10 Oct.'89, pgs 2196-2203.

In view of the above circumstances, it is an object of the present invention to realize an ohmic contact having a very low resistance, which can avoid such a problem in the prior art that, at the time of forming an ohmic contact to an n type GaAs layer using an InₓGa₁₋ₓAs layer, reduction in the carrier concentration of the InₓGa₁₋ₓAs graded-composition layer causes formation of a high-resistance layer.

Thus, the present invention provides a compound semiconductor device having a contact structure comprising:
an n type AlₓGa₁₋ₓAS (0≤x≤1) layer;
an n type InₓGa₁₋ₓGa (0≤x≤1) graded-composition layer formed on then type AlₓGa₁₋ₓ As layer and having a gradually varied composition,
an n type InₓGa₁₋ₓAs (0<x≤1) contact layer having a constant composition formed on the InₓGa₁₋ₓAs graded-composition layer; and
a metal electrode layer connected with the InₓGa₁₋ₓAS contact layer,
the contact structure being so structured that a current flows across the n type AlₓGa₁₋ₓAs layer, the n type InₓGa₁₋ₓAs graded-composition layer and the n type InₓGa₁-ₓAs contact layer,
characterised in that the n type impurity concentration of the InₓGa₁₋ₓAs graded-composition layer has a maximum level within the InₓGa₁₋ₓAs graded-composition layer located in the vicinity of the area of the InₓGa₁₋ₓAs graded-composition layer which is in contact with the AlₓGa₁₋ₓAs constant layer, and that the n type impurity concentration is greater than 3 x 10¹⁹cm⁻³.

Desirably, the carrier concentration of an area within the InₓGa₁₋ₓAs graded-composition layer which area is contacted with the InₓGa₁₋ₓAs contact layer is set higher than a carrier concentration of an area therewithin which area is contacted with the AlₓGa₁₋ₓAs layer.

Preferably also, the n type impurity concentration of an area within the InₓGa₁₋ₓAs graded-composition layer which area is contacted with the InₓGa₁₋ₓAs contact layer is set higher than an n type impurity concentration of an area therewithin which area is contacted with the AlₓGa₁₋ₓAs layer.

The inventors of the present application have studied and conducted many tests on the basis of measurement results of carrier concentration distribution in such an InAs/InₓGa₁₋ₓAs/GaAs structure doped with silicon as shown in Fig. 6, and eventually found the fact that, when the amount of n type impurity doped into the InₓGa₁₋ₓAs graded-composition layer is set to be remarkably large, a large dip or drop in the carrier concentration within the composition layer can be eliminated.

The present invention is based on this fact.

That is in accordance with the present invention, the InₓGa₁₋ₓAs graded-composition layer is doped with an n type impurity which concentration is higher than an n type-activated impurity concentration so that, even when a current is vertically passed through the semiconductor device, a very low contact can be attained.

In this case, when a carrier concentration of an area within the InₓGa₁₋ₓAs graded-composition layer which area is contacted with the InₓGa₁₋ₓAs contact layer is set higher than a carrier concentration of an area therewithin which area is contacted with the AlₓGa₁₋ₓAs layer, the contact resistance can be further reduced.

Further, when an n type impurity concentration of an area within the InₓGa₁₋ₓAs graded-composition layer which area is contacted with the InₓGa₁₋ₓAs contact layer is set higher than an n type impurity concentration of an area therewithin which area is contacted with the AlₓGa₁₋ₓAs layer, the carrier concentration within the graded-composition layer can be increased and the contact resistance can be much more reduced.

From our experimental results, the impurity concentration is set to be above 3x10¹⁹cm⁻³.
Fig. 1 is a cross-sectional view of a heterojunction bipolar transistor
Fig. 2(a) is a graph showing a relationship between n type impurity concentration and depth for respective layers of an emitter contact portion in the transistor of Fig. 1;
Fig. 2(b) is a graph showing a relationship between carrier concentration and depth for the same layers:
Fig. 3(a) is a graph showing a relationship between n type impurity concentration and depth for respective layers of an emitter contact portion in a transistor in accordance with a first embodiment of the present invention;
Fig. 3(b) is a graph showing a relationship between carrier concentration and depth for the layers in the same transistor;
Fig. 4(a) is a graph showing a relationship between n type impurity concentration and depth for respective layers of an emitter contact portion in a transistor in accordance with a second embodiment of the present invention;
Fig. 4(b) is a graph showing a relationship between carrier concentration and depth for the layers in the same transistor;
Fig. 5 shows an ideal energy band for a structure of an n type GaAs layer, n⁺ type InₓGa₁₋ₓAs layer and an InAs electrode; and
Fig. 6 is a graph showing a relationship between carrier concentration and depth for respective layers of a conventional n type GaAs/n⁺ type InₓGa₁₋ₓAs/InAs electrode structure doped with silicon.

Embodiments of the present invention will be detailed with reference to the attached drawings.

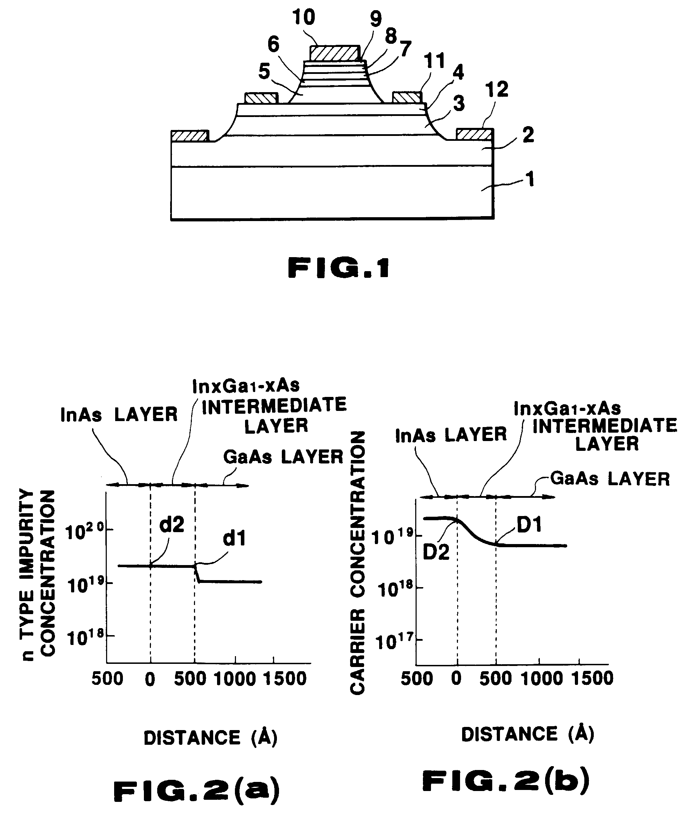

Referring first to Fig. 1, there is shown, in cross section, a heterojunction bipolar transistor which is based on AlGaAs/GaAs heterojunction, useful for understanding the invention.

The illustrated heterojunction bipolar transistor is characterized in that a contact to an emitter layer made up of an n type Al_{0.3}Ga_{0.7}As layer 5 of 2000 Å thickness and an n type AlₓGa₁₋ₓAs graded-composition layer (x=0.3→0) 6 of 300Å thickness comprises an n⁺ type GaAs layer 7 of 500Å thickness, an n⁺ type InₓGa₁₋ₓAs graded-composition layer (x=0→1) 8 of 400Å thickness and an n⁺ type InAs layer 9 of 400Å, and in that the n⁺ type InAs layer 9 and n⁺ type InₓGa₁₋ₓAs layer 8 are set to have both a high impurity concentration of 3.5 x 10¹⁹cm⁻³ and an emitter electrode 10 of Cr/Au material is formed on the n⁺ type InₓGa₁₋ₓAs layer 8. In this case, the measured impurity concentration of the n⁺ type InₓGa₁₋ₓAs layer 8 is 3.5 x 10¹⁹cm⁻³ as shown in Fig. 2(a). Si is used as the n type impurity and Be is used as the p type impurity.

More specifically, in the heterojunction bipolar transistor, its element region includes an n⁺ type GaAs layer 2 of 5000 Å thickness formed on a semi-insulating GaAs substrate 1 as a collector contact layer, an n⁻ type GaAs layer 3 of 5000 Å as a low-concentration collector layer, a p⁺ type GaAs layer 4 of 1000 Å as a base layer, the n type Al_{0.3}Ga_{0.7}As 5 of 2000 Å forming the emitter layer, and the n type AlₓGa₁₋ₓAs graded-composition layer (x = 0.3→ 0) 6 of 300 Å, these layers being sequentially formed in this order. The contact to the emitter layer includes the n⁺ type GaAs layer 7, the n⁺ type InₓGa₁₋ₓAs graded-composition layer (x = 0→ 1) 8 and the n⁺ type InAs layer 9.

The emitter, base and collector electrodes 10, 11 and 12 are provided to the corresponding layers respectively.

The respective semiconductor layers of this heterojunction bipolar transistor are formed on the substrate by one of epitaxial growth techniques including a molecular beam epitaxy technique (MBE technique), a gas source molecular beam epitaxy technique (GSMBE technique) and metal organic CVD technique (MOCVD technique). In the illustrated embodiment, the MBE technique is employed.

In the present embodiment, the x in the n⁺ type InₓGa₁₋ₓAs graded-composition layer (x = 0→ 1) 8 is set to increase from 0 to 1 from its bottom to top, whereby the conduction bands of the n⁺ type GaAs layer 7 and n⁺ type InAs layer 9 can be smoothly connected together.

Actually measured results of the carrier concentration for the n⁺ type GaAs layer 7, n⁺ type InₓGa₁₋ₓAs intermediate layer or graded-composition layer (x = 0→ 1) 8 as an intermediate layer and n⁺ type InAs layer 9 in the HBT are shown in Fig. 2(b). As will be observed from the drawing, a dip in the carrier concentration of the n⁺ type InₓGa₁₋ₓAs intermediate layer is remarkably shallow as compared with that in the prior art.

An emitter contact resistance of the HBT thus obtained was 7 × 10⁻⁸ Ω cm² that is very small compared with 5 × 10⁻⁶ Ω cm² in the prior art HBT.

In this way, in accordance with the HBT of the present invention, since the emitter resistance can be made very low, its transconductance Gm can be improved over the prior art HBT and therefore the HBT of the present invention can be operated in a high current density zone.

With respect to a cut-off frequency f_{T} as one of the performance indexes of a transistor, the present invention has a cut-off frequency f_{T} of 90 GHz that is remarkably improved over 70 GHz of the prior art.

Given below in Table 1 are measurement results of impurity concentration and corresponding contact specific resistance of the HBT having the same structure as above but when only the impurity concentration of the n⁺ type InₓGa₁₋ₓAs intermediate layer 8 is varied.

**TABLE 1**

| n type impurity concentration of InₓGa₁₋ₓAs intermediate layer | Contact specific resistances obtained |
|---|---|
| 5 x 10¹⁸cm⁻³ | About 8 x 10⁻⁶Ω cm² |
| 1.5 x 10¹⁹cm⁻³ | About 5 x 10⁻⁶Ω cm² |
| 3 x 10¹⁹cm⁻³ | About 7 x 10⁻⁸Ω cm² |
| 5 x 10¹⁹cm⁻³ | About 5 x 10⁻⁸Ω cm² |

In this case, the upper limit of the obtained n type carrier concentrations is about 2 x 10¹⁹ cm⁻³ but as will be seen from the above Table 1, when the impurity concentration of the n⁺ type InₓGa₁₋ₓAs intermediate layer 8 is set to be above 3 x 10¹⁹cm⁻³ a very low contact resistance can be obtained.

### Embodiment 1

Explanation will next be made as to an HBT of a first embodiment of the present invention, which has the same structure as the HBT of Fig. 1 and wherein the impurity concentration of the n⁺ type InₓGa₁₋ₓAs graded-composition layer 8 is varied therein.

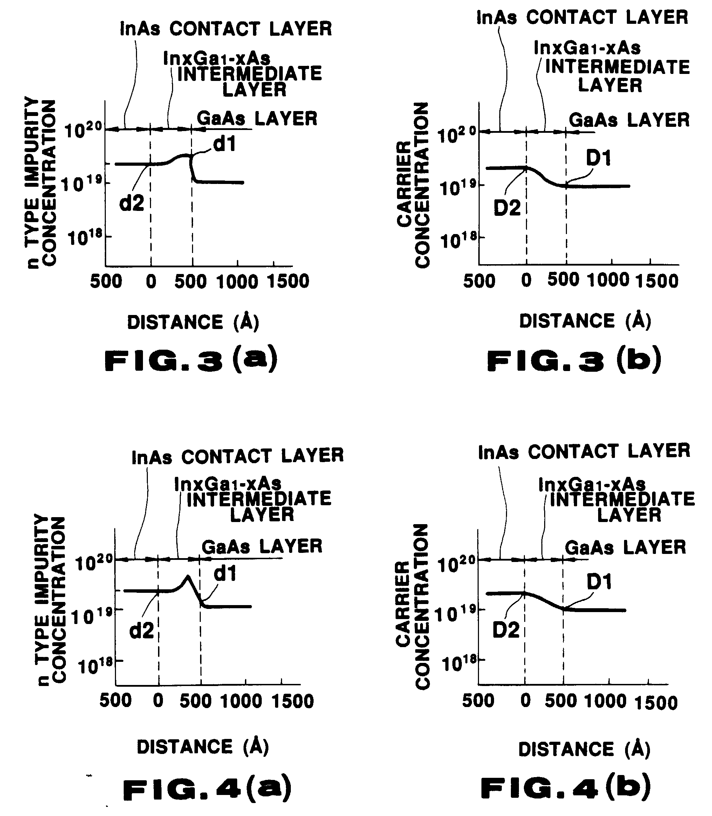

More in detail, in the HBT of the embodiment 1, the n type impurity concentration of the n⁺ type InₓGa₁₋ₓAs graded-composition layer 8 is set to gradually decrease from its side of the n⁺ type GaAs layer 7 to the side of the n⁺ type InAs layer 9, as shown in Fig. 3(a). In other words, the HBT of the present embodiment 1 is arranged so that the n type impurity concentration of the n⁺ type InₓGa₁₋ₓBₓAs graded-composition layer 8 is gradually decreased from its n⁺ type GaAs layer 7 side to its n⁺ type InAs layer 9 side as shown in Fig. 3 (a). That is, the n type impurity concentration d1 of that area of the n⁺ type InₓGa₁₋ₓAs graded-composition layer 8 contacted with the GaAs layer 7 is set higher than the n type impurity concentration d2 of that area of the layer 8 contacted with the n⁺ type InAs layer 9. In the present embodiment, the n type impurity concentration d2 of the layer 8 contacted with the InAs contact layer 9 was set at 3 x 10¹⁹cm⁻³ while the n type impurity concentration d1 of the area contacted with the GaAs layer 7 is set at 5.0 x 10¹⁹cm⁻³.

Fig. 3(b) shows measured results of the carrier concentrations for the n⁺ type GaAs layer 7, n⁺ type InₓGa₁₋ₓAs intermediate or graded-composition layer (x=0→1) 8 and n⁺ type InAs layer 9 of the HBT. It will be appreciated from the drawing that any appreciable dip in the carrier concentration is not present within the n⁺ type InₓGa₁₋ₓAs intermediate layer 8 and the carrier concentration D2 of that area of the n⁺ type InₓGa₁₋ₓAs graded-composition layer 8 which is contacted with the InAs contact layer 9 is higher than the carrier concentration D1 of that area of the layer 8 contacted with the GaAs layer.

The emitter contact resistance of the thus obtained HBT was 3 x 10⁻⁸ Ω cm² that was smaller than the emitter contact resistance of the HBT of Fig. 1 and that was much smaller than 5 x 10⁻⁶ Ω cm² in the prior art HBT.

In this way, in the case of the HBT of the embodiment 1, since the emitter resistance can be made very small, the transconductance Gm can be further improved and the HBT can be operated in a higher current density zone.

With regard to the cut-off frequency f_{τ} as one of the performance indexes of a transistor, the HBT has a cut-off frequency f_{τ} of 100GHz that is much improved over that of the HBT of Fig. 1.

Given below in Table 2 are measurement results of impurity concentration and corresponding contact specific resistance of the HBT having the same structure as above but when only the impurity concentration of the n⁺ type InₓGa₁₋ₓAs intermediate layer 8 is varied.

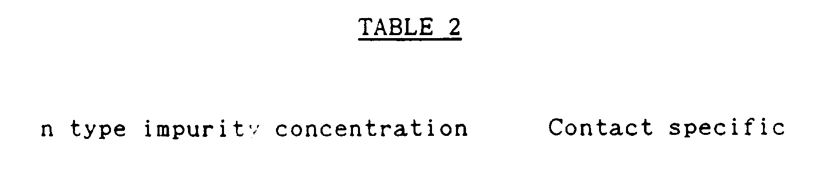

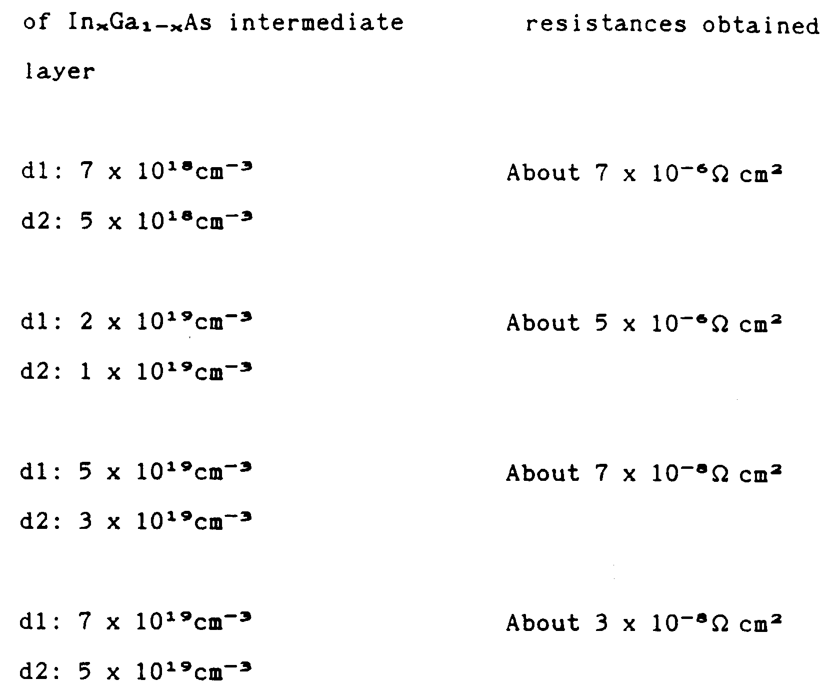

In this case, the upper limit of the obtained n type carrier concentrations is about 2 x 10¹⁹cm⁻³ but as will be seen from the above Table 2, when the impurity concentration of the n⁺ type InₓGa₁₋ₓAs intermediate layer 8 is set to be above 3 x 10¹⁹cm⁻³, a very low contact resistance can be obtained.

### Embodiment 2

In the HBT of the foregoing embodiment 1, the impurity concentration of the n⁺ type InₓGa₁₋ₓAs graded-composition layer 8 has been set to be gradually decreased from its GaAs layer 7 side to its InAs contact layer 9 side. In the present embodiment 3, as shown in Fig. 4(a). the n type impurity concentration of the n⁺ type InₓGa₁₋ₓAs graded-composition layer 8 is set to have a high level in an area within the layer 8 located apart from that area of the layer 8 contacted with the InAs contact layer 9 by a short distance, and to be gradually decreased from the high-level area to that area of the layer 8 contacted with the GaAs layer 7. Fig. 4(b) shows measured results of the carrier concentrations for the n⁺ type GaAs layer 7. n⁺ type InₓGa₁₋ₓAs intermediate or graded-composition layer (x=0→1) 8 and n⁺ type InAs layer 9 of the HBT. It will be observed from the drawing that any appreciable dip in the carrier concentration is not present within the n⁺ type InₓGa₁₋ₓBₓAs intermediate layer 8 and the carrier concentration D2 of that area of the n⁺ type InₓGa₁₋ₓAs graded-composition layer 8 which is contacted with the InAs contact layer 9 is higher than the carrier concentration D1 of that area of the layer 8 contacted with the GaAs layer. And the emitter contact resistance of the thus obtained HBT was 4 x 10⁻ ⁸Ω cm² that was much smaller than the emitter contact resistances of the HBTs of the foregoing embodiment.

The impurity concentration and thickness of the respective semiconductor layers in the HBT are not limited to the particular values used in the foregoing embodiments and may be modified as necessary.

## Claims

1. A compound semiconductor device having a contact structure comprising:
an n type AlₓGa₁₋ₓAS (0≤x≤1) layer (7);
an n type InₓGa₁₋ₓGa (0≤x≤1) graded-composition layer (8) formed on the n type AlₓGa₁₋ₓAs layer (7) and having a gradually varied composition;
an n type InₓGa₁₋ₓAs(0<x≤1) contact layer (9) having a constant composition formed on the InₓGa₁₋ₓAs graded-composition layer (8); and
a metal electrode layer (10) connected with the InₓGa₁₋ₓAs contact layer (9),
the contact structure being so structured that a current flows across the n type AlₓGa₁₋ₓAs layer (7), the n type InₓG₁₋ₓAs graded-composition layer (8) and the n type InₓG₁₋ₓAs contact layer (9),
characterised in that the n type impurity concentration of the InₓGa₁₋ₓAs graded-composition layer (8) has a maximum level within the InₓGa₁₋ₓAs graded-composition layer (8) located in the vicinity of the area of the InₓGa₁₋ₓAs graded-composition layer (8) which is in contact with the AlₓGa₁₋ₓAs layer (7), and that the n type impurity concentration is greater than 3x10¹⁹cm⁻³ in the vicinity of the area of the InₓGa₁₋ₓAs graded composition layer which is in contact with the InₓGa₁₋ₓAs contact layer.

2. A compound semiconductor device according to Claim 1, wherein
the n type impurity concentration of the InₓD₁₋ₓAs graded-composition layer (8) gradually decreases from the area of the maximum level located apart from the interface betweent the InₓGa₁₋ₓAs graded-composition layer (8) and the AlₓGa₁₋ₓAs layer (7), to the interface.

3. A compound semiconductor device according to claim 1 or 2, wherein the maximum of the n type impurity concentration of the InₓG₁₋ₓAs graded-composition layer (8) is located at the interface between the InₓGa₁₋ₓAs graded-composition layer (8) and the AlₓGa₁₋ₓAs layer (7).

4. A compound semiconductor device according to any one of claims I to 3, wherein the compound semiconductor device is an npn type heterojunction bipolar transistor.

## Patentansprüche

1. Verbindungshalbleiterbauelement mit einer Kontaktstruktur, die aufweist:
eine n-leitende AlₓGa₁₋ₓAs-Schicht (7) (0 ≤ x ≤ 1);
eine auf der n-leitenden AlₓGa₁₋ₓAs-Schicht (7) ausgebildete n-leitende InₓGa₁₋ₓAs-Zusammensetzungsgradientenschicht (8) (0 ≤ x ≤ 1) mit allmählich variierender Zusammensetzung;
eine auf der InₓGa₁₋ₓAs-Zusammensetzungsgradientenschicht (8) ausgebildete n-leitende InₓGa₁₋ₓAs-Kontaktschicht (9) (0 < x ≤ 1) mit konstanter Zusammensetzung; und
eine mit der InₓGa₁₋ₓAs-Kontaktschicht (9) verbundene Metallelektrodenschicht (10).
wobei die Kontaktstruktur so strukturiert ist, daß ein Strom quer durch die n-leitende AlₓGa₁₋ₓAs-Schicht (7), die n-leitende InₓGa₁₋ₓAs-Zusammensetzungsgradientenschicht (8) und die n-leitende InₓGa₁₋ₓAs-Kontaktschicht (9) fließt,
dadurch gekennzeichnet, daß die n-Störstellenkonzentration der InₓGa₁₋ₓAs-Zusammensetzungsgradientenschicht (8) eine Maximal konzentration innerhalb der InₓGa₁₋ₓAs-Zusannensetzungsgradientenschicht (8) aufweist. die in der Nähe des Bereichs der InₓGa₁₋ₓAs-Zusammensetzungsgradientenschicht (8) liegt, der sich im Kontakt mit der AlₓGa₁₋ₓAs-Schicht (7) befindet. und daß die n-Störstellenkonzentration in der Nähe des Bereichs der InₓGa₁₋ₓAGs-Zusammensetzungsgradientenschit, der sich im Kontakt mit der InₓGa₁₋ₓAs-Kontaktschicht befindet, größer als 3 · 10¹⁹ cm⁻³ ist.

2. Verbindungshalbleiterbauelement nach Anspruch 1. wobei
die n-Störstellenkonzentration der InₓGal₁₋ₓAs-Zusammensetzungsgradientenschicht (8) vom Bereich maximaler Konzentration, der entfernt von der Grenzfläche zwischen der InₓG₁₋ₓAs-Zusammensetzungsgradientenschicht (8) und der AlₓGa₁₋ₓAs-Schicht (7) liegt. zur Grenzfläche hin allmählich abnimmt.

3. Verbindungshalbleiterbauelement nach Anspruch 1 oder 2, wobei die maximale n-Störstellenkonzentration der InₓGa₁₋ₓAs-Zusammensetzungsgradienten-schicht (8) an der Grenzfläche zwischen der InₓGa₁₋ₓ-Zusammensetzungsgradientenschicht (8) und der AlₓGa₁₋ₓAs-Schicht (7) auftritt.

4. Verbindungshalbleiterbauelement nach einem der Ansprüche 1 bis 3. wobei das Verbindungshalbleiterbauelement ein npn-Bipolartransistor mit Heteroübergang ist.

## Revendications

1. Dispositif à semiconducteur composé ayant une structure de contact comprenant:
une couche (7) de AlₓGa₁₋ₓAs (0 ≤ x ≤ 1) de type n;
une couche à composition graduelle (8) de InₓGa₁₋ₓAs(0 ≤ x ≤ 1) de type n, formée sur la couche (7) de AlₓGa₁₋ₓAs de type n et ayant une composition qui varie graduellement;
une couche de contact (9) de InₓGa₁₋ₓAs (0 < x ≤ 1) de type n, ayant une composition constante et formée sur la couche à composition graduelle (8) de InₓGa₁₋ₓAs; et
une couche d'électrode en métal (10) connectée à la couche de contact (9) en InₓGa₁₋ₓAs,
la structure de contact étant conçue de façon qu'un courant circule à travers la couche (7) de AlₓGa₁₋ₓAs de type n, la couche à composition graduelle (8) de InₓGa₁₋ₓAs de type n et la couche de contact (9) en In_{X}Ga₁₋ₓAs de type n,
caractérisé en ce que la concentration en impuretés de type n dans la couche à composition graduelle (8) de InₓGa₁₋ₓAs a un niveau maximal à l'intérieur de la couche à composition graduelle (8) de InₓGa₁₋ₓAs au voisinage de la région de la couche à composition graduelle (8) de InₓGa₁₋ₓAs qui est en contact avec la couche (7) de AlₓGa₁₋ₓAs, et en ce que la concentration en impuretés de type n est supérieure à 3 x 10¹⁹ cm⁻³ au voisinage de la région de la couche à composition graduelle de InₓGa₁₋ₓAs qui est en contact avec la couche de contact en InₓGa₁₋ₓAs.

2. Dispositif à semiconducteur composé selon la revendication 1, dans lequel
la concentration en impuretés de type n de la couche à composition graduelle (8) de InₓGa₁₋ₓAs diminue progressivement à partir de la région du niveau maximal qui est située à distance de l'interface entre la couche à composition graduelle (8) de InₓGa₁₋ₓAs et la couche (7) de AlₓGa₁₋ₓAs, vers l'interface.

3. Dispositif à semiconducteur composé selon la revendication 1 ou 2, dans lequel le maximum de la concentration en impuretés de type n de la couche à composition graduelle (8) de InₓGa₁₋ₓAs se trouve à l'interface entre la couche à composition graduelle (8) de InₓGa₁₋ₓAs et la couche (7) de AlₓGa₁₋ₓAs.

4. Dispositif à semiconducteur composé selon l'une quelconque des revendications 1 à 3, dans lequel le dispositif à semiconducteur composé est un transistor bipolaire à hétérojonction de type npn.
